# EUROPEAN PATENT APPLICATION

(11) **EP 3 396 727 A1**
(43) Date of publication of application: **31.10.2018**
(21) Application number: 16878475.9
(22) Date of filing: 13.12.2016
(51) Int. Cl.: H01L 51/30, H01L 51/05, H01L 51/40

(54) **COMPOSITION FOR MANUFACTURING ORGANIC SEMICONDUCTOR DEVICE**

(30) Priority: 22.12.2015 JP 2015250363
(71) Applicant: Daicel Corporation, Osaka-shi, Osaka 530-0011 (JP); THE UNIVERSITY OF TOKYO, Tokyo 113-8654 (JP)
(72) Inventor: SUZUKI, Youji, Himeji-shi Hyogo 671-1283 (JP); YOKOO, Takeshi, Himeji-shi Hyogo 671-1283 (JP); AKAI, Yasuyuki, Himeji-shi Hyogo 671-1283 (JP); TAKEYA, Junichi, Tokyo 113-8654 (JP)
(74) Representative: Grünecker Patent- und Rechtsanwälte PartG mbB
(86) International application number: PCT/JP2016/087064
(87) International publication number: WO 2017/110584

(57) **Abstract**

There is provided a composition being excellent in the dissolvability of an organic semiconductor material and being capable of forming an organic semiconductor device having a high carrier mobility by using a printing method under a low-temperature environment. The composition for producing an organic semiconductor device according to the present invention comprises an organic semiconductor material and solvent (A). The organic semiconductor material is an N-shaped fused-ring n-conjugated molecule; and solvent (A) is a compound represented by formula (a). In the formula, L represents a single bond, -O-, -NH-C(=O)-NH-, -C(=O)-, or -C(=S)-; k represents an integer of 0 to 2; R¹ represents a group selected from C₁₋₂₀ alkyl, C₂₋₂₀ alkenyl, C₃₋₂₀ cycloalkyl,-OR^{a}, -SR^{a}, -O(C=O)R^{a}, -R^{b}O(C=O)R^{a} or substituted or unsubstituted amino; and t represents an integer of 1 or more.

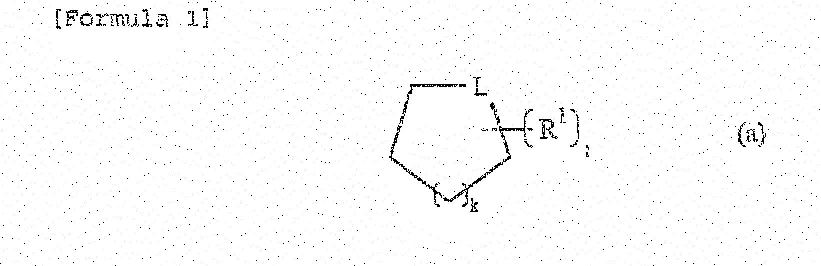

## Description

### Technical Field

The present invention relates to a composition comprising an N-shaped fused-ring π-conjugated molecule being an organic semiconductor material in the state of being dissolved in a solvent, wherein the composition is used for an application of manufacturing an organic semiconductor device by a printing method. The present application claims priority to Japanese Patent Application No. 2015-250363, filed on December 22, 2015, the content of which is hereby incorporated by reference.

### Background of Art

Transistors are important semiconductor devices contained in displays and computer devices, and are now manufactured by using inorganic semiconductor materials such as polysilicon and amorphous silicon. The manufacture of thin-film transistors using inorganic semiconductor materials is carried out by a plasma-enhanced chemical vapor deposition process (PECVD), a sputter process, or the like, which have the following problems: the manufacturing process temperature is high; the manufacturing apparatus is expensive and the costs mount up; and when a large-area thin-film transistor is formed, properties thereof are liable to become nonuniform. Further, depending on the manufacturing process temperature, usable substrates are limited and glass substrates have been mainly used. However, since the glass substrates, though being high in heat resistance, are weak in impact and have difficulty in weight reduction and are poor in flexibility, in the case of using the glass substrates, the formation of lightweight and flexible transistors is difficult.

Then, in recent years, research and developments on organic semiconductor devices utilizing organic semiconductor materials have extensively been carried out. This is because since use of organic semiconductor materials enables the manufacture of organic semiconductor devices at a low manufacturing process temperature by a simple method including a coating method, plastic substrates low in heat resistance can be used and the weight reduction, flexibilization and cost reduction of electronics devices such as displays are enabled to be achieved.

Patent Literature 1 describes an N-shaped fused-ring π-conjugated molecule as an organic semiconductor material. Then, as a solvent for dissolving the organic semiconductor material, use of o-dichlorobenzene, 1,2-dimethoxybenzene or the like is described. The solvent, however, is low in the dissolvability of the organic semiconductor material, and at a manufacturing process temperature of 50°C or less, the organic semiconductor material is insoluble or deposits in many cases. Therefore, it is difficult to form a film by applying an organic semiconductor composition obtained by using the solvent on a plastic substrate low in heat resistance by a printing method. Further since inkjet printing is liable to cause nozzle clogging under a heating condition, it is difficult to use a solvent which cannot hold a dissolution state without being heated. Further since the solvent is strong in toxicity and harmful to health, the solvent has the problem of difficulty with use.

### Citation List

### Patent Literature

Patent Literature 1: International Publication No. WO2014/136827

### Summary of Invention

### Technical Problem

Therefore, an object of the present invention is to provide a composition for manufacturing an organic semiconductor device, the composition being excellent in the dissolvability of an organic semiconductor material and being capable of forming the organic semiconductor device having a high carrier mobility by using a printing method under a low-temperature environment.

### Solution to Problem

As a result of exhaustive studies in order to solve the above problem, the present inventors have found that when a compound represented by the following formula (a) is used as a solvent, the solvent is excellent in dissolvability of an N-shaped fused-ring π-conjugated molecule being an organic semiconductor material even at a low temperature, and an organic semiconductor device can be formed also on a plastic substrate lower in heat resistance than glass substrates, by a printing method. It has also been found that when a composition obtained by dissolving the organic semiconductor material in the solvent is applied on a substrate, the organic semiconductor material crystallizes by the self-organization action and can form an organic semiconductor device having a high carrier mobility. The present invention has been completed based on these findings.

That is, the present invention provides a composition for manufacturing an organic semiconductor device, the composition comprising the following solvent (A) and the following organic semiconductor material.

The solvent (A) is a compound represented by the following formula (a): 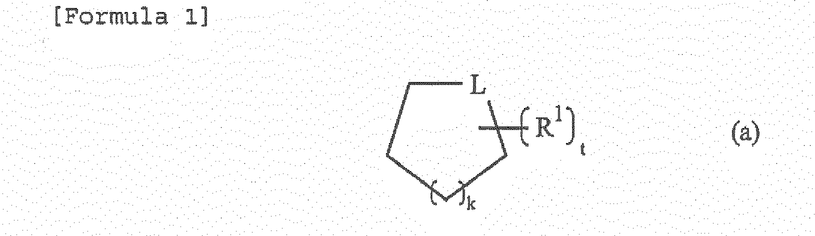 wherein L represents a single bond, -O-, -NH-C(=O)-NH-, - C(=O)-, or -C(=S)-; k represents an integer of 0 to 2; R¹ represents a group selected from C₁₋₂₀ alkyl, C₂₋₂₀ alkenyl, C₃₋₂₀ cycloalkyl, -OR^{a}, -SR^{a}, -O(C=O)R^{a}, -R^{b}O(C=O)R^{a}, wherein R^{a} is selected from C₁₋₇ alkyl, C₆₋₁₀ aryl, or a monovalent group including two or more of the groups bonded to each other via a single bond or a linking group; and R^{b} is selected from C₁₋₇ alkylene, C₆₋₁₀ arylene, or a divalent group including two or more of the groups bonded to each other via a single bond or a linking group or a substituted or unsubstituted amino group; t represents an integer of 1 or more wherein when t is an integer of 2 or more, t occurrences of R¹ are optionally identical or different, and further when t is an integer of 2 or more, two or more R¹ groups selected from t occurrences of R¹ are optionally bonded to each other to form a ring together with one or two or more carbon atoms constituting the ring indicated in the formula; and provided that L is a single bond, t is an integer of 3 or more, and 3 or more R¹ groups selected from t occurrences of R¹ are bonded to each other to form 2 or more rings together with one or two or more carbon atoms constituting the ring indicated in the formula.

The organic semiconductor material is at least one compound selected from compounds represented by the following formula (1-1) and compounds represented by formula (1-2): 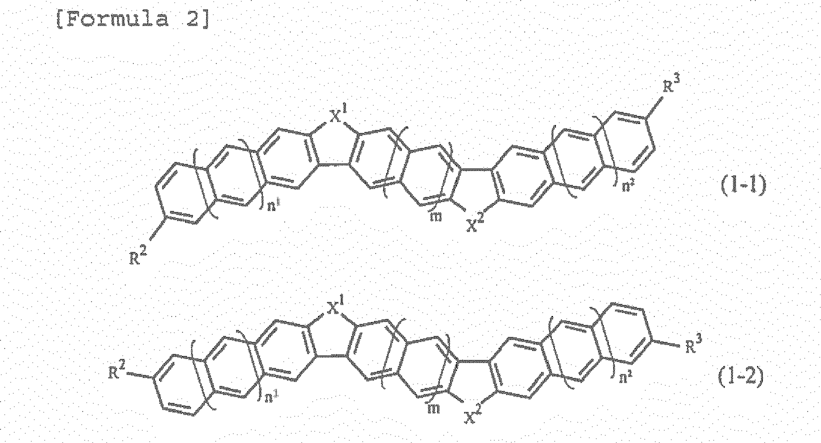 wherein X¹ and X² are identical or different, and are each an oxygen atom, a sulfur atom or a selenium atom; m is 0 or 1; n¹ and n² are identical or different, and are each 0 or 1; R² and R¹ are identical or different, and are each a fluorine atom, C₁₋₂₀ alkyl, C₆₋₁₀ aryl, pyridyl, furyl, thienyl or thiazolyl, wherein one or two or more hydrogen atoms contained in the alkyl group are optionally substituted by a fluorine atom, and one or two or more hydrogen atoms contained in the aryl, pyridyl, furyl, thienyl and thiazolyl are optionally substituted by a fluorine atom or an alkyl group having 1 to 10 carbon atoms.

The present invention further provides the composition for manufacturing an organic semiconductor device wherein the solvent (A) is at least one compound selected from the group consisting of 5 to 7-membered cyclic ketones having a 5 to 7-membered cycloalkyl group or an alkyl group having 1 to 7 carbon atoms as a substituent; fused-ring compounds optionally including an alkyl group having 1 to 3 carbon atoms wherein a benzene ring or a 5 to 7-membered aliphatic ring is fused to a tetrahydrofuran ring; tetrahydrofuran having an alkyl group having 1 to 3 carbon atoms or an alkoxy group having 1 to 3 carbon atoms as a substituent; 1,3-di-C₁₋₃ alkyl-3,4,5,6-tetrahydro-2(1H)-pyrimidinones; and 3,4,5,11-tetrahydroacenaphthene.

The present invention further provides the composition for manufacturing an organic semiconductor device wherein the solvent (A) is at least one compound selected from the group consisting of 2-cyclopentylcyclopentanone, 2-heptylcyclopentanone, 1,3-dimethyl-3,4,5,6-tetrahydro-2(1H)-pyrimidinone, 2,3-dihydrobenzofuran, 2,3-dihydro-2-methylbenzofuran, 2,5-dimethoxytetrahydrofuran, 2,5-dimethyltetrahydrofuran and 3,4,5,11-tetrahydroacenaphthene.

The present invention further provides the composition for manufacturing an organic semiconductor device, the composition further comprising solvent (B).

The solvent (B) is a compound having an SP value at 25°C of 6.0 to 8.0 [(cal/cm³)^{0.5}]

The present invention further provides the composition for manufacturing an organic semiconductor device, wherein the solvent (B) is at least one compound selected from the group consisting of alkanes having 6 to 18 carbon atoms and dialkyl ethers having 6 to 18 carbon atoms.

The present invention further provides the composition for manufacturing an organic semiconductor device, wherein the total content of the solvent (A) and the solvent (B) in the total amount of solvents contained in the composition for manufacturing an organic semiconductor device is 80% by weight or more, and the content ratio of the solvent (A) to the solvent (B) (the solvent (A)/the solvent (B), in weight ratio) is 100/0 to 75/25.

The present invention further provides the composition for manufacturing an organic semiconductor device, wherein the organic semiconductor material is a compound represented by formula (2): 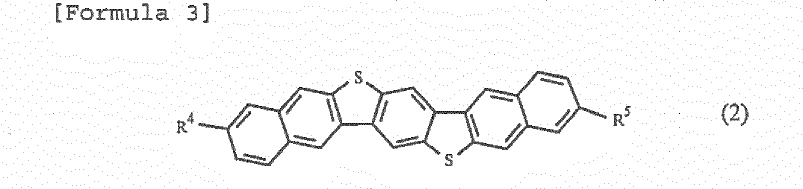 wherein R⁴ and R⁵ are identical or different, and are each C₁₋₂₀ alkyl, C₆₋₁₀ aryl, pyridyl, furyl, thienyl or thiazolyl.

That is, the present invention relates to the following.
[1] A composition for manufacturing an organic semiconductor device, the composition comprising the following solvent (A) and the following organic semiconductor material,
   the solvent (A) is a compound represented by the formula (a),
   the organic semiconductor material is at least one compound selected from compounds represented by the formula (1-1) and compounds represented by the formula (1-2) .
[2] The composition for manufacturing an organic semiconductor device according to [1], wherein the molecular weight of the solvent (A) is 70 to 350.
[3] The composition for manufacturing an organic semiconductor device according to [1] or [2], wherein the SP value at 25°C by the Fedors method of the solvent (A) is 8.0 to 11.0 [(cal/cm³)^{0.5}].
[4] The composition for manufacturing an organic semiconductor device according to any one of [1] to [3], wherein the solvent (A) is at least one compound selected from the group consisting of 5 to 7-membered cyclic ketones having a 5 to 7-membered cycloalkyl group or an alkyl group having 1 to 7 carbon atoms as a substituent; fused-ring compounds which may have an alkyl group having 1 to 3 carbon atoms in which a benzene ring or a 5 to 7-membered aliphatic ring is fused to a tetrahydrofuran ring; tetrahydrofuran having an alkyl group having 1 to 3 carbon atoms or an alkoxy group having 1 to 3 carbon atoms as a substituent; 1,3-di-C₁₋₃ alkyl-3,4,5,6-tetrahydro-2(1H)-pyrimidinones; and 3,4,5,11-tetrahydroacenaphthene.
[5] The composition for manufacturing an organic semiconductor device according to any one of [1] to [3], wherein the solvent (A) is at least one compound selected from the group consisting of 2-cyclopentylcyclopentanone, 2-heptylcyclopentanone, 1,3-dimethyl-3,4,5,6-tetrahydro-2(1H)-pyrimidinone, 2,3-dihydrobenzofuran, 2,3-dihydro-2-methylbenzofuran, 2,5-dimethoxytetrahydrofuran, 2,5-dimethyltetrahydrofuran and 3,4,5,11-tetrahydroacenaphthene.
[6] The composition for manufacturing an organic semiconductor device according to any one of [1] to [5], further comprising the following solvent (B).
   The solvent (B): a compound having an SP value at 25°C of 6.0 to 8.0 [(cal/cm³)^{0.5}]
[7] The composition for manufacturing an organic semiconductor device according to [6], wherein the solvent (B) is at least one compound selected from the group consisting of alkanes having 6 to 18 carbon atoms and dialkyl ethers having 6 to 18 carbon atoms.
[8] The composition for manufacturing an organic semiconductor device according to [6] or [7], wherein the total content of the solvent (A) and the solvent (B) in the total amount of solvents contained in the composition for manufacturing an organic semiconductor device is 80% by weight or more, and the content ratio of the solvent (A) to the solvent (B) (the solvent (A)/the solvent (B), in weight ratio) is 100/0 to 75/25.
[9] The composition for manufacturing an organic semiconductor device according to any one of [1] to [8], wherein the proportion of the solvent (A) in the total amount of solvents contained in the composition is 70% by weight or more.
[10] The composition for manufacturing an organic semiconductor device according to any one of [1] to [9], wherein the organic semiconductor material is at least one compound selected from compounds represented by the formula (1-1) and compounds represented by the following formula (1-2).
[11] The composition for manufacturing an organic semiconductor device according to any one of [1] to [9], wherein the organic semiconductor material is a compound represented by the formula (2).
[12] The composition for manufacturing an organic semiconductor device according to any one of [1] to [9], wherein the organic semiconductor material is at least one compound selected from the group consisting of compounds represented by the formulae (2-1) to (2-6).
[13] The composition for manufacturing an organic semiconductor device according to any one of [1] to [12], wherein the content of the solvent (A) in the total amount of the composition is 70 to 99.97% by weight.
[14] The composition for manufacturing an organic semiconductor device according to any one of [6] to [13], wherein the content of the solvent (B) in the total amount of the composition is 0 to 30% by weight.
[15] The composition for manufacturing an organic semiconductor device according to any one of [1] to [14], wherein the content of the organic semiconductor material is 0.02 parts by mass or more with respect to 100 parts by mass of the solvent (A) (in the case of comprising the solvent (B) also, the total of the solvent (A) and the solvent (B)).

### Advantageous Effects of Invention

The composition for manufacturing an organic semiconductor device according to the present invention is excellent in the dissolvability of an N-shaped fused-ring π-conjugated molecule being an organic semiconductor material even under a low-temperature environment, and poses no problem of insolubility and deposition. Hence, organic semiconductor devices can be formed directly on plastic substrates which, though being lower in heat resistance than glass substrates, are strong in impact, and light in weight and flexible; and displays and computer devices which are strong in impact and light in weight and flexible can be formed. Further organic semiconductor devices can be produced by using a printing method such as inkjet printing and the large cost reduction is enabled.

Then, when the composition for manufacturing an organic semiconductor device according to the present invention is applied on substrates, since the organic semiconductor material crystallizes by the self-organization action, organic semiconductor devices having a high crystallinity and a high carrier mobility can be formed.

### Description of Embodiments

The composition for manufacturing an organic semiconductor device

The composition for producing an organic semiconductor device according to the present invention comprises the following organic semiconductor material and solvent (A).

### Solvent (A)

The solvent (A) in the present invention is a compound represented by the following formula (a). The composition for manufacturing an organic semiconductor device according to the present invention comprises one or two or more compounds represented by the following formula (a).

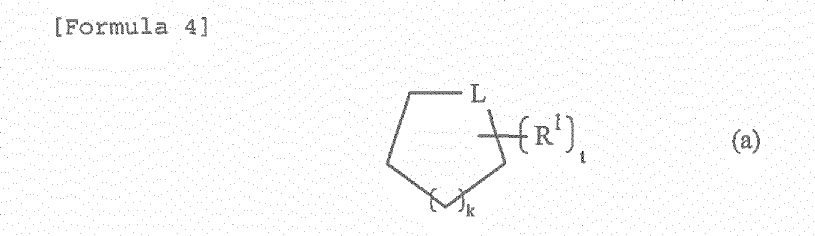

In the above formula, L represents a single bond, - O-, -NH-C(=O)-NH-, -C(=O)-, or -C(=S)-; k represents an integer of 0 to 2; R¹ is a substituent which binds to atoms constituting the ring indicated in the formula (a), and represents a C₁₋₂₀ alkyl group, a C₂₋₂₀ alkenyl group, a C₃₋₂₀ cycloalkyl group, an -OR^{a} group, an -SR^{a} group, an -O(C=O)R^{a} group, an -R^{b}O(C=O)R^{a} group (R^{a} represents a C₁₋₇ alkyl group, a C₆₋₁₀ aryl group, or a monovalent group in which two or more of the above groups are bonded through a single bond or a linking group; and R^{b} represents a C₁₋₇ alkylene group, a C₆₋₁₀ arylene group, or a divalent group in which two or more of the above groups are bonded through a single bond or a linking group) or a substituted or unsubstituted amino group; t represents an integer of 1 or more wherein when t is an integer of 2 or more, t occurrences of R¹ may be identical or different, and further when t is an integer of 2 or more, two or more R¹ groups selected from t occurrences of R¹ may be bonded to each other to form a ring together with one or two or more carbon atoms constituting the ring indicated in the formula; and provided that L is a single bond, t is an integer of 3 or more, and 3 or more R¹ groups selected from t occurrences of R¹ are bonded to each other to form 2 or more rings together with one or two or more carbon atoms constituting the ring indicated in the formula.

Examples of the C₁₋₂₀ (having 1 to 20 carbon atoms) alkyl group in R¹ include straight-chain or branched-chain alkyl groups such as a methyl group, an ethyl group, a propyl group, an isopropyl group, an n-butyl group, a t-butyl group, an n-pentyl group, an n-hexyl group, an n-heptyl group, an n-decyl group, an n-undecyl group and an n-tetradecyl group.

Examples of the C₂₋₂₀ (having 2 to 20 carbon atoms) alkenyl group in R¹ include straight-chain or branched-chain alkenyl groups such as a vinyl group, an allyl group and a 1-butenyl group.

Examples of the C₃₋₂₀ (having 3 to 20 carbon atoms) cycloalkyl group in R¹ include cycloalkyl groups having about 3 to 20 (preferably 3 to 15, especially preferably 5 to 8) carbon atoms such as a cyclopropyl group, a cyclobutyl group, a cyclopentyl group, a cyclohexyl group and a cyclooctyl group; cycloalkenyl groups having about 3 to 20 (preferably 3 to 15, especially preferably 5 to 8) carbon atoms such as a cyclopentenyl group and a cyclohexenyl group; and crosslinked cyclic hydrocarbon groups such as a perhydronaphthalen-1-yl group, a norbornyl group, an adamantyl group, a tricyclo [5.2.1.0^{2,6}]decan-8-yl group and a tetracyclo[4.4.0.1²,⁵.1^{7,10}]dodecan-3-yl group.

Examples of the C₁₋₇ (having 1 to 7 carbon atoms) alkyl group in R^{a} include straight-chain or branched-chain alkyl groups such as a methyl group, an ethyl group, a propyl group, an isopropyl group, an n-butyl group, a t-butyl group, an n-pentyl group, an n-hexyl group and an n-heptyl group.

Examples of the C₆₋₁₀ (having 6 to 10 carbon atoms) aryl group in R^{a} include a phenyl group, a naphthyl group, a fluorenyl group and a biphenylyl group.

Examples of the C₁₋₇ (having 1 to 7 carbon atoms) alkylene group in R^{b} include straight-chain or branched-chain alkylene groups such as a methylene group, a methylmethylene group, a dimethylmethylene group, an ethylene group, a propylene group and a trimethylene group.

Examples of the C₆₋₁₀ (having 6 to 10 carbon atoms) arylene group in R^{b} include a phenylene group.

The "monovalent group in which two or more of the above groups are bonded through a single bond or a linking group" in R^{a} is a group in which two or more groups selected from C₁₋₇ alkyl groups and C₆₋₁₀ aryl groups are bonded through a single bond or a linking group. Examples of the linking group include a carbonyl group (-CO-), an ether bond (-O-), an ester bond (-COO-), an amido bond (-CONH-) and a carbonate bond (-OCOO-).

The "divalent group in which two or more of the above groups are bonded through a single bond or a linking group" in R^{b} is a group in which two or more groups selected from C₁₋₇ alkylene groups and C₆₋₁₀ arylene groups are bonded through a single bond or a linking group. The linking group includes the same examples as those of the linking group in R^{a}.

Examples of the substituted or unsubstituted amino group include mono- or di- (C₁₋₃) alkylamino groups such as an amino group, a methylamino group, an ethylamino group, an isopropylamino group, a dimethylamino group and a diethylamino group.

When t is an integer of 2 or more, two or more groups selected from t occurrences of R¹ may be bonded to each other to form a ring together with one or two or more carbon atoms constituting the ring indicated in the formula; and examples of the ring which may be formed include 5 to 7-membered alicyclic rings such as cyclopentane, cyclohexane and cycloheptane, and a benzene ring.

When L is a single bond, t is an integer of 3 or more, and 3 or more groups selected from t occurrences of R¹ are bonded to each other to form 2 or more rings together with one or two or more carbon atoms constituting the ring indicated in the formula. Therefore, when L is a single bond, the compound represented by the formula (a) is a fused ring having 3 or more rings; and the fused ring may further have a substituent R¹.

The molecular weight of the compound represented by the formula (a) or the solvent (A) is, for example, about 350 or less, preferably 70 to 250, and especially preferably 80 to 200.

The SP value of the compound represented by the formula (a) or the solvent (A) at 25°C by the Fedors method is, for example, 7.0 to 11.0 [(cal/cm³)^{0.5}], preferably 8.0 to 11.0 (cal/cm³)^{0.5}], and especially preferably 9.0 to 10.5 [(cal/cm³)^{0.5}].

The compound represented by the formula (a) (or the solvent (A)) is, among the above, preferably at least one compound selected from the group consisting of 5 to 7-membered cyclic ketones having a 5 to 7-membered cycloalkyl group or an alkyl group having 1 to 5 carbon atoms as a substituent; fused-ring compounds which may have an alkyl group having 1 to 3 carbon atoms in which a benzene ring or a 5 to 7-membered aliphatic ring is fused to a tetrahydrofuran ring; tetrahydrofuran having an alkyl group having 1 to 3 carbon atoms or an alkoxy group having 1 to 3 carbon atoms as a substituent; 1,3-di-C₁₋₃ alkyl-3,4,5,6-tetrahydro-2(1H)-pyrimidinones; and 3,4,5,11-tetrahydroacenaphthene.

Specific examples of the compound represented by the formula (a) (or the solvent (A)) include C₁₋₇ (cyclo)alkylcyclopentanones (for example, 2-methylcyclopentanone, 2-ethylcyclopentanone, 2-propylcyclopentanone, 2-butylcyclopentanone, 2-pentylcyclopentanone, 2-cyclopentylcyclopentanone, 2-hexylcyclopentanone and 2-heptylcyclopentanone), C₁₋₇ (cyclo)alkylcyclohexanones (for example, 2-methylcyclohexanone, 2-ethylcyclohexanone, 2-propylcyclohexanone, 2-butylcyclohexanone, 2-pentylcyclohexanone, 4-pentylcyclohexanone, 2-hexylcyclohexanone and 2-heptylcyclohexanone), cyclohexyl methyl ether, cyclohexylamine, 2,5-dimethoxytetrahydrofuran, 2,5-dimethyltetrahydrofuran, 2,3-dihydrobenzofuran, 2,3-dihydro-2-methylbenzofuran, 2,3-dihydro-3-methylbenzofuran, cyclohexyl acetate, dihydroterpinyl acetate, tetrahydrofurfuryl acetate, dipropylene glycol cyclopentyl methyl ether, 1,3-dimethyl-3,4,5,6-tetrahydro-2(1H)-pyrimidinone and 3,4,5,11-tetrahydroacenaphthene. These can be used singly or in combinations of two or more. Here, the above "(cyclo)alkyl" indicates an alkyl or a cycloalkyl.

As the compound represented by the formula (a) (or the solvent (A)), particularly at least one compound, which is selected from the group consisting of 2-cyclopentylcyclopentanone, 2-heptylcyclopentanone, 1,3-dimethyl-3,4,5,6-tetrahydro-2(1H)-pyrimidinone, 2,3-dihydrobenzofuran, 2,3-dihydro-2-methylbenzofuran, 2,5-dimethoxytetrahydrofuran, 2,5-dimethyltetrahydrofuran and 3,4,5,11-tetrahydroacenaphthene, is preferable in the point of being excellent in the dissolvability of the organic semiconductor material.

The content proportion of the compound represented by the formula (a) (or the solvent (A)) (in the case of containing two or more in combination, the total amount thereof) in the total amount (100% by weight) of solvents contained in the composition for manufacturing an organic semiconductor device is, for example, 50% by weight or more (for example, 50 to 100% by weight), preferably 70% by weight or more (for example, 70 to 100% by weight), and especially preferably 80% by weight or more (for example, 80 to 100% by weight). When the content of the compound represented by the formula (a) (or the solvent (A)) is below the above range, the dissolvability of the organic semiconductor material is likely to decrease.

### The solvent (B)

The composition for manufacturing an organic semiconductor device according to the present invention may comprise, besides the solvent (A), one or two or more of solvents (solvent (B)) which are usually used in applications to electronic materials and are compatible with the solvent (A).

The solvent (B) is preferably a compound having an SP value at 25°C by the Fedors method of 6.0 to 8.0 [(cal/cm³)^{0.5}] (particularly 7.0 to 8.0 [(cal/cm³)^{0.5}]).

Examples of the solvent (B) include alkanes having 6 to 18 carbon atoms and dialkyl ethers having 6 to 18 carbon atoms.

Examples of the alkanes having 6 to 18 carbon atoms include straight-chain or branched-chain alkanes (preferably straight-chain or branched-chain alkanes having 8 to 12 carbon atoms, especially preferably branched-chain alkanes having 8 to 12 carbon atoms) such as hexane, octane, 2-methyloctane, nonane, 2-methylnonane, decane, tetradecane and octadecane.

Examples of the dialkyl ethers having 6 to 18 carbon atoms include straight-chain or branched-chain dialkyl ethers (preferably straight-chain or branched-chain dialkyl ethers having 10 to 14 carbon atoms, especially preferably straight-chain dialkyl ethers having 10 to 14 carbon atoms) such as methyl hexyl ether, hexyl ether (= dihexyl ether), octyl ether (= dioctyl ether) and bis(2-ethylhexyl) ether.

In the case of concurrently using the solvent (A) and the solvent (B), the mixing ratio (the solvent (A)/the solvent (B), in weight ratio) is, for example, 100/0 to 75/25, and preferably 100/0 to 80/20. When the proportion of the solvent (B) is excessive, the dissolvability of the organic semiconductor material is likely to decrease. Here, in the case of using two or more solvents in combination as the solvent (A), the amount of the solvent (A) is the total amount thereof. The same is applied to the solvent (B).

The composition for manufacturing an organic semiconductor device according to the present invention may further comprise, besides the solvent (A) and the solvent (B), other solvents, but the proportion of the total content of the solvent (A) and the solvent (B) (in the case of containing two or more solvents in combination, the total content of all the solvents) in the total amount (100% by weight) of solvents contained in the composition is, for example, 50% by weight or more (for example, 50 to 100% by weight), preferably 70% by weight or more (for example, 70 to 100% by weight), and especially preferably 80% by weight or more (for example, 80 to 100% by weight). Therefore, the content of the solvents other than the solvent (A) and the solvent (B) is, with respect to the total amount (100% by weight) of solvents contained in the composition for manufacturing an organic semiconductor device, for example, 50% by weight or less, preferably 30% by weight or less, more preferably 20% by weight or less, especially preferably 10% by weight or less, and most preferably 5% by weight or less.

The composition for manufacturing an organic semiconductor device according to the present invention, since comprising the solvent (A) and as required, the solvent (B), has a high dissolvability of the organic semiconductor material even at a relatively low temperature. For example, the solubility at 40°C of a compound represented by the above formula (1-1) or the following formula (1-2) is, with respect to 100 parts by weight of the solvent (A) (in the case of concurrently using the solvent (A) and the solvent (B), 100 parts by weight of the total of the solvent (A) and the solvent (B)), for example, 0.02 part by weight or more, preferably 0.03 part by weight or more, and especially preferably 0.04 part by weight or more. The upper limit of the solubility is, for example, 1 part by weight, preferably 0.5 part by weight, and especially preferably 0.1 part by weight.

### The organic semiconductor material

The composition for manufacturing an organic semiconductor device according to the present invention comprises, as the organic semiconductor material, at least one selected from compounds represented by the following formula (1-1) and compounds represented by the following formula (1-2): 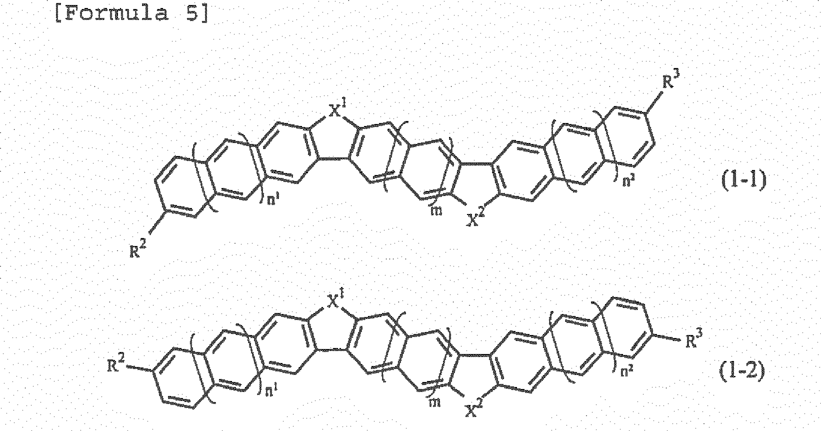 wherein X¹ and X² are identical or different, and are each an oxygen atom, a sulfur atom or a selenium atom; m is 0 or 1; n¹ and n² are identical or different, and are each 0 or 1; R² and R³ are identical or different, and are each a fluorine atom, a C₁₋₂₀ alkyl group, a C₆₋₁₀ aryl group, a pyridyl group, a furyl group, a thienyl group or a thiazolyl group, wherein one or two or more hydrogen atoms contained in the above alkyl group may be replaced by a fluorine atom, and one or two or more hydrogen atoms contained in the above aryl group, pyridyl group, furyl group, thienyl group and thiazolyl group may be replaced by a fluorine atom or an alkyl group having 1 to 10 carbon atoms.

X¹ and X² are identical or different, and are each an oxygen atom, a sulfur atom or a selenium atom; among these, an oxygen atom or a sulfur atom is preferable particularly in the point of providing a high carrier mobility, and a sulfur atom is especially preferable.

m is 0 or 1, and preferably 0.

n¹ and n² are identical or different, and are each 0 or 1, and 0 is preferable in the point of providing excellent dissolvability.

The C₁₋₂₀ alkyl group in R² and R³ includes the same examples as those of the C₁₋₂₀ alkyl group in R¹. In the present invention, among these examples, C₄₋₁₅ alkyl groups are preferable; C₆₋₁₂ alkyl groups are especially preferable; and C₆₋₁₀ alkyl groups are most preferable.

The C₆₋₁₀ aryl group in R² and R³ includes the same examples as those of the C₆₋₁₀ aryl group in R¹. In the present invention, among the examples, a phenyl group is preferable.

Examples of the pyridyl group include a 2-pyridyl group, a 3-pyridyl group and a 4-pyridyl group.

Examples of the furyl group include a 2-furyl group and a 3-furyl group.

Examples of the thienyl group include a 2-thienyl group and a 3-thienyl group.

Examples of the thiazolyl group include a 2-thiazolyl group.

One or two or more hydrogen atoms contained in the aryl group, pyridyl group, furyl group, thienyl group and thiazolyl group may be replaced by an alkyl group having 1 to 10 carbon atoms. Examples of the alkyl group having 1 to 10 carbon atoms include straight-chain or branched-chain alkyl groups such as a methyl group, an ethyl group, a propyl group, an isopropyl group, an n-butyl group, a t-butyl group, an n-pentyl group, an n-hexyl group, an n-heptyl group and an n-decyl group. Among these, alkyl groups having 1 to 6 carbon atoms are preferable, and alkyl groups having 1 to 3 carbon atoms are especially preferable. Examples of, for example, a group in which at least one hydrogen atom contained in the aryl group is replaced by an alkyl group having 1 to 10 carbon atoms include a tolyl group and a xylyl group.

Examples of a group in which at least one hydrogen atom contained in the aryl group is replaced by a fluorine atom include a p-fluorophenyl group and a pentafluorophenyl group.

R² and R³ are identical to or different from each other, and are preferably selected from the group consisting of a C₁₋₂₀ alkyl group, a C₆₋₁₀ aryl group, a pyridyl group, a furyl group, a thienyl group or a thiazolyl group, particularly in the point of providing a high carrier mobility.

Among compounds represented by the above formula (1-1) and compounds represented by the above formula (1-2), the compounds represented by the above formula (1-2) are especially preferable in that the compounds can hold a crystal state even under a high-temperature environment of more than 200°C and are excellent in thermal stability.

As the organic semiconductor material in the present invention, a compound represented by the following formula (2) is especially preferable.

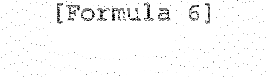

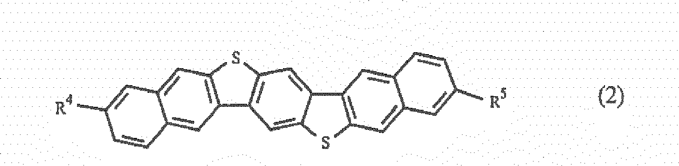

In the above formula, R⁴ and R⁵ are identical or different, and are each a C₁₋₂₀ alkyl group, a C₆₋₁₀ aryl group, a pyridyl group, a furyl group, a thienyl group or a thiazolyl group; and examples thereof include the same examples as those of the C₁₋₂₀ alkyl group, the C₆₋₁₀ aryl group, the pyridyl group, the furyl group, the thienyl group and the thiazolyl group in R² and R³. R⁴ and R⁵ are, particularly in the point of providing a high carrier mobility, preferably the same group, and especially preferably a C₁₋₂₀ alkyl group, a phenyl group, a furyl group or a thienyl group, and particularly preferably a C₁₋₂₀ alkyl group (among these, preferably a C₄₋₁₅ alkyl group, especially preferably a C₆₋₁₂ alkyl group, and most preferably a C₆₋₁₀ alkyl group) .

As the organic semiconductor material in the present invention, at least one compound selected from the group consisting of compounds represented by the following formulae (2-1) to (2-6) is especially preferable in the point of providing a high carrier mobility.

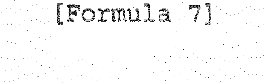

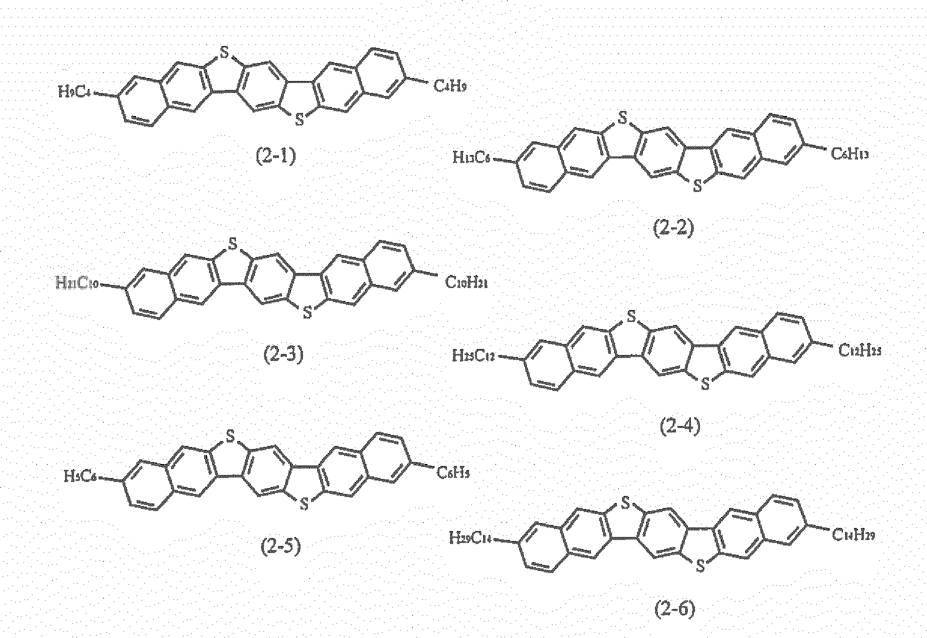

The compounds represented by the above formula (1-1) and the compounds represented by the above formula (1-2) can be produced by a manufacture method described in International Publication No. WO2014/136827, and the like. Further commercially available products, for example, trade names: "C₁₀-DNBDT-NW" and "C₆-DNBDT-NW" (manufactured by Pi-Crystal Co., Ltd.) can also be used.

The compounds represented by the above formula (1-1) and the compounds represented by the above formula (1-2) form an N-shaped molecular structure in which benzene rings range to both wings with crosslinked parts by chalcogen atoms becoming bending points, and have the structure in which benzene rings of both terminals are each substituted with a substituent. Hence, as compared with straight molecules having nearly the same number of rings, these compounds are high in the dissolvability to the solvent (A), or a mixture of the solvent (A) and the solvent (B), and hardly deposit even under a low-temperature environment.

The composition for manufacturing an organic semiconductor device according to the present invention may comprise organic semiconductor materials other than the compounds represented by the above formula (1-1) and the compounds represented by the above formula (1-2); but the proportion of a compound represented by the above formula (1-1) and compound represented by the above formula (1-2) contained in the composition (in the case of containing two or more, the proportion of the total amount thereof) in the total amount (100% by weight) of organic semiconductor materials contained in the composition is, for example, 50% by weight or more (for example, 50 to 100% by weight), preferably 70% by weight or more (for example, 70 to 100% by weight), and especially preferably 80% by weight or more (for example, 80 to 100% by weight).

### The composition for manufacturing an organic semiconductor device

The composition for manufacturing an organic semiconductor device according to the present invention comprises the solvent (A) (as required, the solvent (A) and the solvent (B)) as a solvent and at least one compound selected from compounds represented by the formula (1-1) and compounds represented by the formula (1-2), as an organic semiconductor material. The solvents and the organic semiconductor materials can each be used singly or in combinations of two or more.

The composition for manufacturing an organic semiconductor device according to the present invention can be prepared, for example, by mixing the solvent (A) (as required, the solvent (A) and the solvent (B)) and the organic semiconductor material, and heating the mixture in an air atmosphere, nitrogen atmosphere or argon atmosphere at a temperature of about 70 to 150°C for 0.1 to 5 hours.

The content of the solvent (in the case of containing two or more, the total amount thereof) in the total amount of the composition for manufacturing an organic semiconductor device according to the present invention is, for example, 99.999% by weight or less. The lower limit thereof is, for example, 90.000% by weight, preferably 93.000% by weight, and especially preferably 95.000% by weight; and the upper limit is preferably 99.990% by weight.

The content of the solvent (A) (in the case of containing two or more, the total amount thereof) in the total amount of the composition for manufacturing an organic semiconductor device according to the present invention is, for example, 70 to 99.97% by weight. The lower limit of the content of the solvent (A) is preferably 80% by weight, and especially preferably 85% by weight; and the upper limit is preferably 95% by weight, and especially preferably 92% by weight.

The content of the solvent (B) (in the case of containing two or more, the total amount thereof) in the total amount of the composition for manufacturing an organic semiconductor device according to the present invention is, for example, 0 to 30% by weight. The lower limit of the content of the solvent (B) is preferably 5% by weight, and especially preferably 8% by weight; and the upper limit is preferably 20% by weight, and especially preferably 15% by weight.

The content of the organic semiconductor material (particularly a compound represented by the formula (1-1) and a compound represented by the formula (1-2)) (in the case of containing two or more, the total amount thereof) in the composition for manufacturing an organic semiconductor device according to the present invention is, with respect to 100 parts by weight of the solvent, for example, 0.02 part by weight or more, preferably 0.03 part by weight or more, and especially preferably 0.04 part by weight or more. The upper limit of the content of the organic semiconductor material is, for example, 1 part by weight, preferably 0.5 part by weight, and especially preferably 0.1 part by weight.

In the composition for manufacturing an organic semiconductor device according to the present invention, in addition to the above solvent and organic semiconductor material, as required, components (for example, an epoxy resin, an acryl resin, a cellulose resin, and a butyral resin) usually contained in compositions for manufacturing organic semiconductor devices can suitably be blended.

Due to the use of solvent (A) (solvent (A) and solvent (B), as required) as a solvent, the composition for manufacturing an organic semiconductor device according to the present invention can dissolve a compound represented by the formula (1-1) or compound represented by the formula (1-2), the organic semiconductor material, in a high concentration even at a relatively low temperature. Hence, the easy formation of an organic semiconductor device is enabled by a simple method using a wet process such as a printing method even under a low-temperature environment (for example, 20 to 50°C, preferably 20 to 40°C), and a large cost reduction is enabled. Further the organic semiconductor device can be formed directly on a plastic substrate which though being lower in heat resistance than glass substrates, is resistant to impact, light in weight and flexible, and displays and computer devices which are strong in impact, light in weight and flexible can be formed. Further, when the composition for manufacturing an organic semiconductor device according to the present invention is applied on a substrate, the organic semiconductor material contained in the composition crystallizes by the self-organization action and an organic semiconductor device having a high carrier mobility (for example, 0.2 cm²/Vs or more, preferably 1.0 cm²/Vs or more, especially preferably 4.0 cm²/Vs or more, further especially preferably 5.0 cm²/Vs or higher, and most preferably 7.0 cm²/Vs or more) can be obtained. Further, the solvent (A) and the solvent (B) are preferable also in the point of being superior in safety to 1,2-dimethoxybenzene and o-dichlorobenzene conventionally used.

### Examples

Hereinafter, the present invention will be described more specifically by way of Examples, but the present invention is not any more limited to these Examples.

### Example 1

50 parts by weight of 2-cyclopentylcyclopentanone and 50 parts by weight of 1,3-dimethyl-3,4,5,6-tetrahydro-2(1H)-pyrimidinone were mixed to thereby prepare a solvent (1).

"C₁₀-DNBDT-NW" as an organic semiconductor material was mixed in the solvent (1) under a 25°C environment so that the concentration of the organic semiconductor material became 0.03% by weight, and heated in a nitrogen atmosphere under the light-shielded condition at 100°C for 3 hours to thereby obtain a composition for manufacturing an organic semiconductor device. For the obtained composition for manufacturing an organic semiconductor device, the dissolution of the organic semiconductor material was visually checked.

The composition for manufacturing an organic semiconductor device whose dissolution had been confirmed was cooled at a rate of -10°C/hour, and the dissolution of the organic semiconductor material was visually checked at every temperature; and the solubility of the "C₁₀-DNBDT-NW" to the solvent (1) was evaluated from the temperature (°C) at the time when the organic semiconductor material deposited.

### Examples 2 to 9, and Comparative Examples 1 and 2

Respective compositions for manufacturing an organic semiconductor device were prepared as in Example 1, except for using a solvent(s) indicated in Table 1, and the dissolvability of the organic semiconductor material was evaluated.

### [Table 1]

**Table 1**

| | Solvent (A) | | | | Solvent (B) | | | Other Solvents | | Dissolvability Deposition Temperature | Mobility (cm²/Vs) |
|---|---|---|---|---|---|---|---|---|---|---|---|
| | CPCPAN | DMTHP | DHBF | DMTHF | 2MOC | 2MNO | DHE | DMOB | o-DCB | | |
| SP Value | 9.2 | 10.4 | 10.0 | 9.1 | 7.4 | 7.5 | 7.9 | 10.0 | 9.9 | | |
| Example 1 | 50 | 50 | - | - | - | - | - | - | - | 40°C | 5.9 |
| Example 2 | 45 | 45 | - | - | 10 | - | - | - | - | 25°C | 7.8 |
| Example 3 | 30 | 60 | - | - | 10 | - | - | - | - | 40°C | 1.7 |
| Example 4 | - | 90 | - | - | - | 10 | - | - | - | 25°C | 0.4 |
| Example 5 | - | 90 | - | - | - | - | 10 | - | - | 25°C | 5.5 |
| Example 6 | - | - | 100 | - | - | - | - | - | - | 50°C | 12 |
| Example 7 | - | - | 90 | - | - | 10 | - | - | - | 25°C | 0.4 |
| Example 8 | - | - | 60 | 30 | - | 10 | - | - | - | 25°C | 0.06 |
| Example 9 | - | - | 90 | - | - | - | 10 | - | - | 40°C | 4.5 |
| Comparative Example 1 | - | - | - | - | - | - | - | 100 | - | 100°C | 3.2 |
| Comparative Example 2 | - | - | - | - | - | - | - | - | 100 | 35°C | 1.1 |

### Example 10

"C₁₂-DNBDT-NW" as an organic semiconductor material was mixed in 2,3-dihydrobenzofuran under a 25°C environment so that the concentration of the organic semiconductor material became 0.03% by weight, and heated in a nitrogen atmosphere under the light-shielded condition at 100°C for 3 hours to thereby obtain a composition for manufacturing an organic semiconductor device. For the obtained composition for manufacturing an organic semiconductor device, the dissolution of the organic semiconductor material was visually checked.

The composition for manufacturing an organic semiconductor device whose dissolution had been confirmed was cooled at a rate of -10°C/hour, and the dissolution of the organic semiconductor material was visually checked at every temperature; and the solubility of the "C₁₂-DNBDT-NW" to 2,3-dihydrobenzofuran was evaluated from the temperature (°C) at the time when the organic semiconductor material deposited.

### Comparative Examples 3 and 4

Respective compositions for producing an organic semiconductor device were prepared as in Example 10, except for using a solvent indicated in Table 2, and the dissolvability of the organic semiconductor material was evaluated.

### [Table 2]

**Table 2**

| | Solvent (A) | Other Solvents | | Dissolvability Deposition Temperature | Mobility (cm²/Vs) |
|---|---|---|---|---|---|
| | DHBF | DMOB | o-DCB | | |
| SP Value | 10.0 | 10.0 | 9.9 | | |
| Example 10 | 100 | - | - | 60°C | 2.5 |
| Comparative Example 3 | - | 100 | - | 50°C | 0.3 |
| Comparative Example 4 | - | - | 100 | 70°C | 1.2 |

### Example 11

"C₁₄-DNBDT-NW" as an organic semiconductor material was mixed in 2,3-dihydrobenzofuran under a 25°C environment so that the concentration of the organic semiconductor material became 0.03% by weight, and heated in a nitrogen atmosphere under the light-shielded condition at 100°C for 3 hours to thereby obtain a composition for manufacturing an organic semiconductor device. For the obtained composition for manufacturing an organic semiconductor device, the dissolution of the organic semiconductor material was visually checked.

The composition for manufacturing an organic semiconductor device whose dissolution had been confirmed was cooled at a rate of -10°C/hour, and the dissolution of the organic semiconductor material was visually checked at every temperature; and the solubility of the "C₁₄-DNBDT-NW" to 2,3-dihydrobenzofuran was evaluated from the temperature (°C) at the time when the organic semiconductor material deposited.

### Comparative Examples 5 and 6

Respective compositions for manufacturing organic semiconductor devices were prepared as in Example 11, except for using a solvent indicated in Table 3, and the dissolvability of the organic semiconductor material was evaluated.

### [Table 3]

**Table 3**

| | Solvent (A) | Other Solvents | | Dissolvability Deposition Temperature | Mobility (cm²/Vs) |
|---|---|---|---|---|---|
| | DHBF | DMOB | o-DCB | | |
| SP Value | 10.0 | 10.0 | 9.9 | | |
| Example 11 | 100 | - | - | 60°C | 2.2 |
| Comparative Example 5 | - | 100 | - | 50°C | 0.2 |
| Comparative Example 6 | - | - | 100 | 70°C | 0.1 |

The organic semiconductor materials and the solvents used in the Examples and the Comparative Examples will be described in the below.

### The organic semiconductor materials

- C₁₀-DNBDT-NW: a compound represented by the following formula (2-3), trade name: "C₁₀-DNBDT-NW", manufactured by Pi-Crystal Co., Ltd. 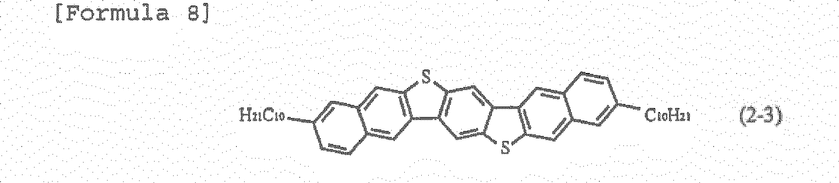
- C₁₂-DNBDT-NW: a compound represented by the following formula (2-4), trade name: "C₁₂-DNBDT-NW", manufactured by Daicel Corp. 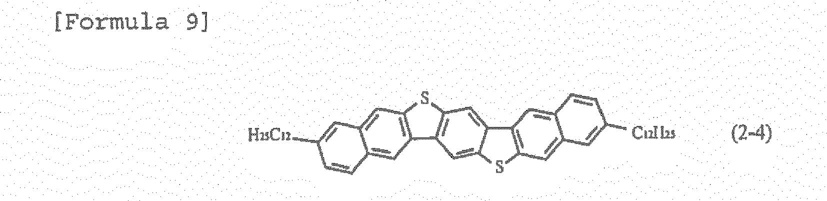
- C₁₄-DNBDT-NW: a compound represented by the following formula (2-6), trade name: "C₁₄-DNBDT-NW", manufactured by Daicel Corp. 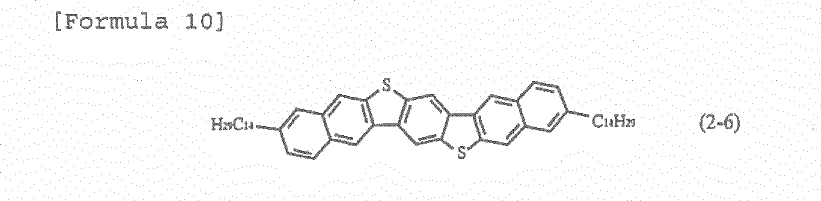 The solvents (A)
- CPCPAN: 2-cyclopentylcyclopentanone, manufactured by Tokyo Chemical Industry Co., Ltd.
- DMTHP: 1,3-dimethyl-3,4,5,6-tetrahydro-2(1H)-pyrimidinone, manufactured by Tokyo Chemical Industry Co., Ltd.
- DHBF: 2,3-dihydrobenzofuran, manufactured by Tokyo Chemical Industry Co., Ltd.
- DMTHF: 2,5-dimethyltetrahydrofuran, manufactured by Tokyo Chemical Industry Co., Ltd.
   The solvents (B)
- 2MOC: 2-methyloctane, manufactured by Tokyo Chemical Industry Co., Ltd.
- 2MNO: 2-methylnonane, manufactured by Tokyo Chemical Industry Co., Ltd.
- DHE: hexyl ether, manufactured by Tokyo Chemical Industry Co., Ltd.
   Other solvents
- DMOB: 1,2-dimethoxybenzene, manufactured by Tokyo Chemical Industry Co., Ltd.
- o-DCB: o-dichlorobenzene, manufactured by Tokyo Chemical Industry Co., Ltd.

### Industrial Applicability

The composition for manufacturing an organic semiconductor device according to the present invention is excellent in the dissolvability of an N-shaped fused-ring π-conjugated molecule being an organic semiconductor material even under a low-temperature environment, and poses no problem of insolubility and deposition. Hence, organic semiconductor devices can be formed directly on plastic substrates which, though being lower in heat resistance than glass substrates, are resistant to impact, light in weight and flexible, and displays and computer devices which are resistant to impact and light in weight and flexible can be formed. Further organic semiconductor devices can be produced by using a printing method such as printing and the large cost reduction is enabled.

Then, when the composition for manufacturing an organic semiconductor device according to the present invention is applied on substrates, since the organic semiconductor material crystallizes by the self-organization action, organic semiconductor devices having a high crystallinity and a high carrier mobility can be formed.

## Claims

1. A composition for manufacturing an organic semiconductor device, the composition comprising a solvent (A) and an organic semiconductor material,
the solvent (A) is a compound represented by formula (a) : 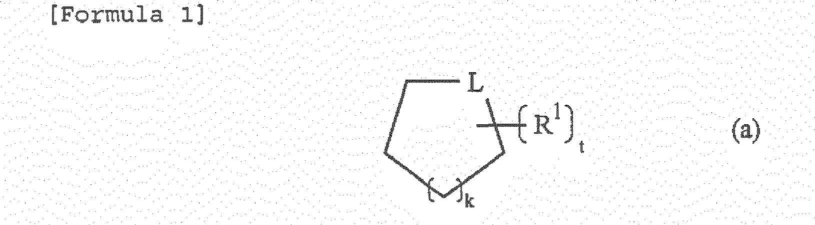 wherein L represents a single bond, -O-, -NH-C(=O)-NH-, -C(=O)-, or -C(=S)-;
k represents an integer of 0 to 2;
R¹ represents a group selected from C₁₋₂₀ alkyl, C₂₋₂₀ alkenyl, C₃₋₂₀ cycloalkyl, -OR^{a}, -SR^{a}, -O(C=O)R^{a},-R^{b}O(C=O)R^{a}, wherein R^{a} is selected from C₁₋₇ alkyl, C₆₋₁₀ aryl, or a monovalent group including two or more of the groups bonded to each other via a single bond or a linking group; and
R^{b} is selected from C₁₋₇ alkylene, C₆₋₁₀ arylene, or a divalent group including two or more of the groups bonded to each other via a single bond or a linking group or a substituted or unsubstituted amino group;
t represents an integer of 1 or more wherein when t is an integer of 2 or more, t occurrences of R¹ are optionally identical or different, and further when t is an integer of 2 or more, two or more groups selected from t occurrences of R¹ are optionally bonded to each other to form a ring together with one or two or more carbon atoms constituting the ring indicated in the formula; and
provided that L is a single bond, t is an integer of 3 or more, and 3 or more groups selected from t occurrences of R¹ are bonded to each other to form 2 or more rings together with one or two or more carbon atoms constituting the ring indicated in the formula; and
the organic semiconductor material is at least one compound selected from compounds represented by formula (1-1) and compounds represented by formula (1-2): 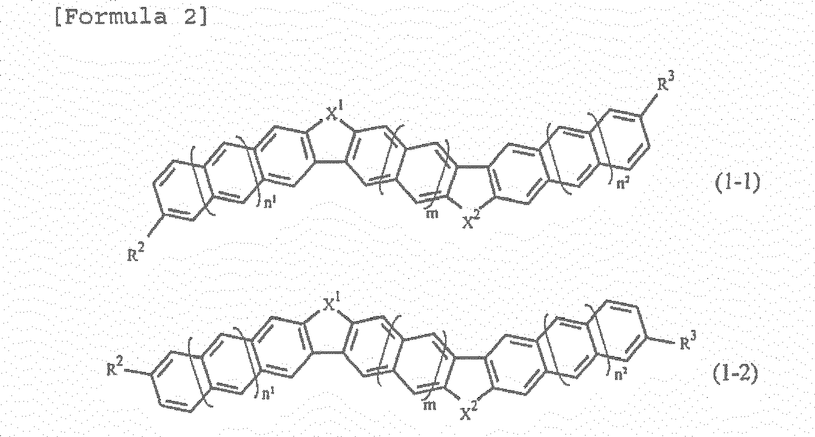 wherein X¹ and X² are identical or different, and are each an oxygen atom, a sulfur atom or a selenium atom;
m is 0 or 1;
n¹ and n² are identical or different, and are each 0 or 1;
R² and R³ are identical or different, and are each a fluorine atom, C₁₋₂₀ alkyl, C₆₋₁₀ aryl, pyridyl, furyl, thienyl or thiazolyl, wherein one or two or more hydrogen atoms contained in the alkyl are optionally substituted by a fluorine atom, and one or two or more hydrogen atoms contained in the aryl, pyridyl, furyl, thienyl and thiazolyl are optionally substituted by a fluorine atom or an alkyl group having 1 to 10 carbon atoms.

2. The composition for manufacturing an organic semiconductor device according to claim 1, wherein the solvent (A) is at least one compound selected from the group consisting of 5 to 7-membered cyclic ketones having a 5 to 7-membered cycloalkyl group or an alkyl group having 1 to 7 carbon atoms as a substituent; fused-ring compounds optionally including an alkyl group having 1 to 3 carbon atoms wherein a benzene ring or a 5 to 7-membered aliphatic ring is fused to a tetrahydrofuran ring; tetrahydrofuran having an alkyl group having 1 to 3 carbon atoms or an alkoxy group having 1 to 3 carbon atoms as a substituent; 1,3-di-C₁₋₃ alkyl-3,4,5,6-tetrahydro-2(1H)-pyrimidinones; and 3,4,5,11-tetrahydroacenaphthene.

3. The composition for manufacturing an organic semiconductor device according to claim 1, wherein the solvent (A) is at least one compound selected from the group consisting of 2-cyclopentylcyclopentanone, 2-heptylcyclopentanone, 1,3-dimethyl-3,4,5,6-tetrahydro-2(1H)-pyrimidinone, 2,3-dihydrobenzofuran, 2,3-dihydro-2-methylbenzofuran, 2,5-dimethoxytetrahydrofuran, 2,5-dimethyltetrahydrofuran and 3,4,5,11-tetrahydroacenaphthene.

4. The composition for manufacturing an organic semiconductor device according to claim any one of claims 1 to 3, further comprising solvent (B) being a compound having an SP value at 25°C of 6.0 to 8.0 [(cal/cm³)^{0.5}].

5. The composition for manufacturing an organic semiconductor device according to claim 4, wherein the solvent (B) is at least one compound selected from the group consisting of alkanes having 6 to 18 carbon atoms and dialkyl ethers having 6 to 18 carbon atoms.

6. The composition for manufacturing an organic semiconductor device according to claim 4 or 5, wherein a total content of the solvent (A) and the solvent (B) in a total amount of solvents contained in the composition for manufacturing an organic semiconductor device is 80% by weight or more; and a content ratio of the solvent (A) to the solvent (B) (the solvent (A)/the solvent (B), in weight ratio) is 100/0 to 75/25.

7. The composition for manufacturing an organic semiconductor device according to any one of claims 1 to 6, wherein the organic semiconductor material is a compound represented by formula (2): 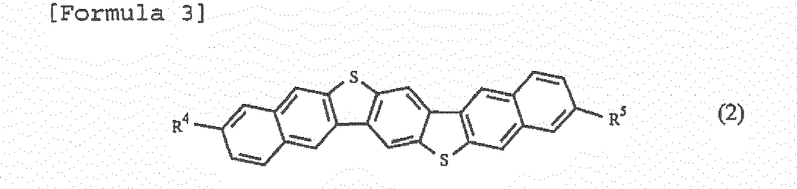 wherein R⁴ and R⁵ are identical or different, and are each C₁₋₂₀ alkyl, C₆₋₁₀ aryl, pyridyl, furyl, thienyl or thiazolyl.
